# EUROPEAN PATENT APPLICATION

(11) **EP 4 645 373 A1**
(43) Date of publication of application: **05.11.2025**
(21) Application number: 23911312.9
(22) Date of filing: 04.10.2023
(51) Int. Cl.: H01L 21/31, C23C 16/44, C23C 16/52, H01L 21/22, H01L 21/324

(54) **TEMPERATURE CONTROL METHOD, SEMICONDUCTOR DEVICE MANUFACTURING METHOD, SUBSTRATE TREATMENT DEVICE, AND PROGRAM**

(30) Priority: 26.12.2022 JP 2022209067
(71) Applicant: Kokusai Electric Corporation, Tokyo 101-0045 (JP)
(72) Inventor: NAKANISHI, Kento, Toyama-shi, Toyama 939-2393 (JP); MURATA, Hitoshi, Toyama-shi, Toyama 939-2393 (JP); UENO, Masaaki, Toyama-shi, Toyama 939-2393 (JP); YAMAGUCHI, Hideto, Toyama-shi, Toyama 939-2393 (JP)
(74) Representative: Verscht, Thomas Kurt Albert
(86) International application number: PCT/JP2023/036229
(87) International publication number: WO 2024/142528

(57) **Abstract**

The present invention can achieve an improvement in the speed of temperature rise in a low-temperature range. Provided is a temperature control method comprising a treatment temperature setting step for controlling heating in and cooling for a reaction tube to make the temperature of a substrate placed inside the reaction tube be a preset treatment temperature, the treatment temperature setting step including: a temperature raising step for supplying a certain amount of electric power and raising the temperature of a heater wire disposed on the outside of the reaction tube higher than a treatment temperature; and a cooling gas supplying step for supplying a cooling gas to the reaction tube.

## Description

### [Technical Field]

The present disclosure relates to a temperature control method, a method of manufacturing a semiconductor device, a substrate processing apparatus and a program.

### [Related Art]

As a part of a manufacturing process of a semiconductor device, a predetermined process is performed on a wafer (hereinafter, also referred to as a "substrate") (for example, see Patent Documents 1 to 3). According to the Patent Documents, a technique capable of controlling a process temperature (at which the wafer is processed) is described. Recently, a temperature at which the wafer is processed tends to decrease. When a temperature control is performed at a low temperature, a temperature of a heater wire used for the temperature control is also low. Therefore, a long wavelength radiation is mainly emitted. When such a long wavelength radiation is absorbed by a reaction tube, it may reduce a temperature increase speed of the wafer.

### [Related Art Document]

### [Patent Document]

Patent Document 1: Japanese Patent Laid-Open No. 2000-181549
Patent Document 2: International Patent Publication No. WO 2018-100826
Patent Document 3: Japanese Patent Laid-Open No. 2014-209569

### [Disclosure]

### [Technical Problem]

According to the present disclosure, there is provided a technique capable of improving a temperature increase speed in a low temperature range.

### [Technical Solution]

According to an embodiment of the present disclosure, there is provided a technique that includes: a process temperature setting step of adjusting a temperature of a substrate arranged in a reaction tube to a predetermined process temperature by controlling a heating of an inside of the reaction tube and a cooling of the inside the reaction tube, wherein the process temperature setting step comprises: a temperature increasing step of increasing a temperature of a heater wire provided outside the reaction tube to become higher than the process temperature by supplying a constant amount of an electric power to the heater wire; and a cooling gas supply step of supplying a cooling gas toward the reaction tube.

### [Advantageous Effects]

According to some embodiments of the present disclosure, it is possible to improve a temperature increase speed in a low temperature range.

### [Brief Description of Drawings]

FIG. 1 is a diagram schematically illustrating a cross-section of a substrate processing apparatus according to embodiments of the present disclosure.
FIG. 2A is a diagram schematically illustrating a cross-section taken along a line 2A - 2A of the substrate processing apparatus shown in FIG. 1.
FIG. 2B is a diagram schematically illustrating another cross-section taken along a line 2B - 2B of the substrate processing apparatus shown in FIG. 1.
FIG. 3 is a diagram schematically illustrating a configuration of a controller of the substrate processing apparatus according to the embodiments of the present disclosure, and schematically illustrating a relationship between the controller and a semiconductor manufacturing apparatus.
FIG. 4 is a diagram schematically illustrating a hardware configuration of a control computer of the substrate processing apparatus according to the embodiments of the present disclosure.
FIG. 5 is a diagram schematically illustrating cross-sections of a heating structure and a reaction tube in which a substrate is accommodated.
FIG. 6A is a diagram schematically illustrating an example of a temperature control performed when a substrate processing is being performed by the substrate processing apparatus 10 according to the embodiments of the present disclosure.
FIG. 6B is a graph schematically illustrating a relationship between a temperature of the substrate and a heater output.
FIG. 7 is a graph schematically illustrating a relationship between the heater output and time according to a modified example of the present disclosure.
FIG. 8 is a flow chart schematically illustrating an example of a temperature-related process in a film forming process according to the embodiments of the present disclosure.
FIG. 9 is a diagram schematically illustrating a temperature change in an inner temperature of a furnace in the flow chart shown in FIG. 8.

### [Detailed Description]

Hereinafter, embodiments of the technique of the present disclosure will be described in detail with reference to the drawings. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. Like reference numerals represent like components in the drawings.

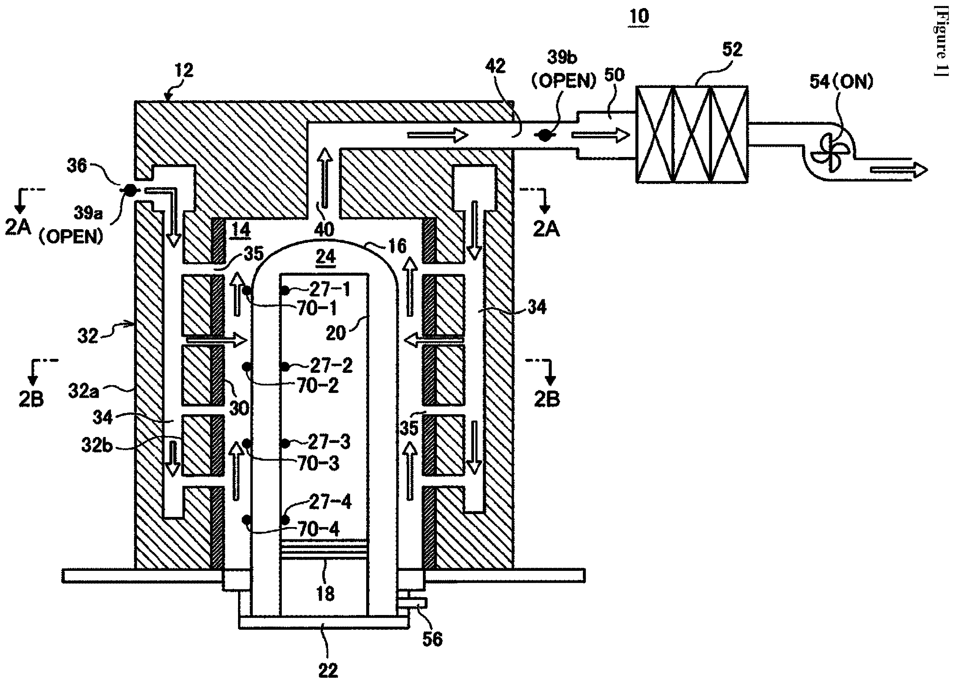

As shown in FIG. 1, a substrate processing apparatus 10 according to the present embodiments may include: a heating apparatus 12 of a cylindrical shape; a reaction tube 16 of a cylindrical shape accommodated in an inner side of the heating apparatus 12 by being surrounded by a furnace space 14; and a boat 20 provided in the reaction tube 16 and capable of accommodating (supporting) substrates 18 to be processed in the reaction tube 16. The boat 20 is configured to support the substrates 18 in the reaction tube 16 with an interval (gap) therebetween while the substrates 18 accommodated in the boat 20 are vertically arranged in a horizontal orientation in a multistage manner. The boat 20 is placed on a boat elevator (not shown) through a boat cap 22, and configured to be capable of being elevated or lowered by the boat elevator. Therefore, the boat 20 with the substrates 18 can be transferred (loaded) into the reaction tube 16 and transferred (unloaded) out of the reaction tube 16 by an operation of the boat elevator. In addition, a process chamber 24 in which the substrates 18 are accommodated is defined by the reaction tube 16. A gas introduction pipe (not shown) is connected to the reaction tube 16, and a reactive gas supply source (not shown) is connected to the gas introduction pipe. In addition, a gas exhaust pipe 56 is connected to the reaction tube 16, and a gas in the process chamber 24 is exhausted through the gas exhaust pipe 56.

The heating apparatus 12 serving as a heater unit is of a cylindrical shape. As shown in FIG. 1, the heating apparatus 12 includes at least a heating structure 30 provided at an inner side of a heat insulating structure in which a plurality of heat insulators are stacked. The heating structure 30 includes a heat insulator (not shown) and a heater wire 30a provided at the heat insulator so as to face the furnace space 14.

In addition, the heating apparatus 12 further includes: a side wall structure (side wall portion) 32 of a cylindrical shape and serving as a heat insulating structure; and an upper wall structure (upper wall portion) 33 configured to cover an upper end of the side wall structure 32 and serving as a heat insulating structure.

The side wall structure 32 is configured as a multilayer structure. That is, the side wall structure 32 includes a side wall outer layer 32a serving as an outer side layer of the multilayer structure of the side wall structure 32 and a side wall inner layer 32b serving as an inner side layer of the multilayer structure of the side wall structure 32. A cylindrical space 34 serving as a cooling gas passage is provided between the side wall outer layer 32a and the side wall inner layer 32b. In addition, the heating structure 30 is provided in an inner side of the side wall inner layer 32b, and an inner portion of the heating structure 30 (which includes a heat generating structure described later) serves as a heat generating region (heat generating area). The furnace space 14 and the cylindrical space 34 communicate with each other via a plurality of blowout holes (ejection holes) 35. While the present embodiments will be described by way of an example in which the side wall structure 32 is configured as the multilayer structure in which a plurality of heat insulators are stacked, the side wall structure 32 is not limited to such a structure.

A cooling gas supply port 36 is provided at an upper portion of the side wall outer layer 32a.

A rapid-cooling exhaust port (also referred to as a "quenching exhaust port") 40 communicating with the furnace space 14 is provided at a center portion of the cooling gas supply port 36 located approximately at its horizontal center.

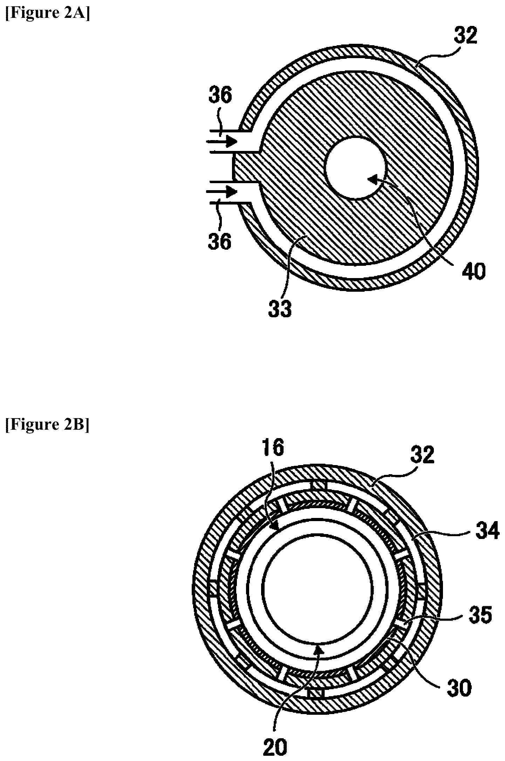

In addition, as shown in FIG. 2B, the plurality of blowout holes 35 are provided in a desired distribution in the side wall inner layer 32b below the cooling gas supply port 36. As shown in FIG. 1, the furnace space 14 and the cylindrical space 34 communicate with each other via the blowout holes 35 extending substantially in the horizontal direction. That is, a cooling gas is ejected (blown out) from the cylindrical space 34 to the furnace space 14 through the blowout holes 35 such that the reaction tube 16 can be cooled. As shown in FIG. 1, the blowout holes 35 are provided in the horizontal direction, but are not limited thereto. For example, the blowout holes 35 may be inclined so as to face the quenching exhaust port 40.

As shown in FIG. 2A, the quenching exhaust port 40 of a circular shape is provided in the upper wall structure, and the quenching exhaust port 40 is located on a central axis of the heating apparatus 12. In addition, a rapid-cooling gas exhaust port (also referred to as a "quenching gas exhaust port") 42 is provided on an upper side surface of the upper wall structure 33, and is connected to the quenching exhaust port 40.

In addition, the quenching gas exhaust port 42 is connected to a duct 50, and a radiator 52 and an exhaust fan 54 are connected to the duct 50 in a manner that the radiator 52 is located more upstream than the exhaust fan 54 in a gas flow direction. The cooling gas heated by the heating apparatus 12 is discharged (exhausted) to an outside of the apparatus through the duct 50, the radiator 52 and the exhaust fan 54 described above.

According to the present embodiments, a valve 39a capable of being opened and closed is provided in the vicinity of the cooling gas supply port 36. In addition, a valve 39b capable of being opened and closed is provided in the vicinity of the quenching gas exhaust port 42 and the duct 50.

A supply of the cooling gas is adjusted by opening or closing the valve 39a and turning on or off the exhaust fan 54, and the cooling gas can be discharged through the quenching gas exhaust port 42 via the cylindrical space 34 serving as the cooling gas passage. According to the present embodiments, when the exhaust fan 54 is operated and the cooling gas is discharged through the quenching gas exhaust port 42, a pressure (inner pressure) of the furnace space 14 becomes a negative pressure, and the cooling gas whose temperature is low is supplied (or sucked in) through the cooling gas supply port 36. The cooling gas (whose temperature is low) supplied through the cooling gas supply port 36 is blown out (or ejected) through the cylindrical space 34 and the blowout holes 35 toward the reaction tube 16 in the furnace space 14. As a result, the reaction tube 16 is cooled. According to the present embodiments, components such as the exhaust fan 54, the quenching gas exhaust port 42, the blowout holes 35, the cylindrical space 34 and the cooling gas supply port 36 may serve as an example of a cooling structure of the present disclosure.

As shown in FIG. 1, a detector (which is a detecting structure) 27 serving as a first detector configured to detect a temperature of the substrate 18 is provided in the reaction tube 16. The detector 27 is provided to be rotatable together with the boat 20. For example, measuring structures of the detector 27 are disposed between the substrates 18 accommodated in the multistage manner in the boat 20. In addition, the detector 27 may be constituted by four temperature sensors (which are a first substrate temperature sensor 27-1, a second substrate temperature sensor 27-2, a third substrate temperature sensor 27-3 and a fourth substrate temperature sensor 27-4 from an upper end to a lower end thereof). In addition, as a second detector, a first reaction tube temperature sensor 70-1, a second reaction tube temperature sensor 70-2, a third reaction tube temperature sensor 70-3 and a fourth reaction tube temperature sensor 70-4 are provided in the vicinity of the reaction tube 16. In FIG. 1, four substrate temperature sensors (that is, the first substrate temperature sensor 27-1 to the fourth substrate temperature sensor 27-4) and four reaction tube temperature sensors (that is, the first reaction tube temperature sensor 70-1 to the fourth reaction tube temperature sensor 70-4) are provided. However, its number is not limited to four, and may be changed as appropriate depending on a type of a film and process conditions. According to the present embodiments, four substrate temperature sensors may be collectively or individually referred to as a "substrate temperature sensor 27" (that is, the first detector 27), and four reaction tube temperature sensors may be collectively or individually referred to as a "reaction tube temperature sensor 70" (that is, the second detector 70). For example, the first substrate temperature sensor 27 is a general term for the first substrate temperature sensor 27-1, the second substrate temperature sensor 27-2, the third substrate temperature sensor 27-3 and the fourth substrate temperature sensor 27-4. In addition, although not shown, a temperature sensor serving as a third detector is provided in the vicinity of the heating structure 30.

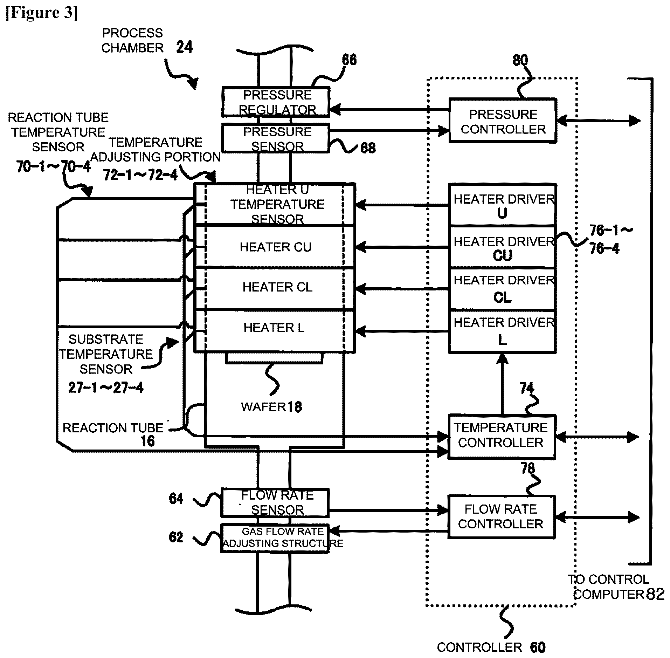

FIG. 3 is a diagram schematically illustrating a configuration of a controller (which is a control apparatus) 60, and a relationship between the controller 60 and the substrate processing apparatus 10. As shown in FIG. 3, the process chamber 24 is provided with the substrate temperature sensor 27, the reaction tube temperature sensor 70, a gas flow rate regulator (which is a gas flow rate adjusting structure) 62, a flow rate sensor 64, a pressure regulator (which is a pressure adjusting structure) 66 and a pressure sensor 68.

As shown in FIG. 3, the first to fourth substrate temperature sensors 27-1, 27-2, 27-3 and 27-4 of the process chamber 24 are disposed in temperature adjusting portions (which serve as the heat generating region of the heating apparatus 12) 72-1, 72-2, 72-3 and 72-4, respectively, and configured to measure the temperatures of the substrates 18 corresponding to the temperature adjusting portions 72-1, 72-2, 72-3 and 72-4, respectively.

The first to fourth reaction tube temperature sensors 70-1, 70-2, 70-3 and 70-4 are disposed in the cylindrical space 34 in a manner corresponding to the temperature adjusting portions 72-1, 72-2, 72-3 and 72-4, respectively, and configured to measure an inner temperature distribution of the cylindrical space 34. In addition, according to the present embodiments, since the first to fourth reaction tube temperature sensors 70-1, 70-2, 70-3 and 70-4 are disposed in the vicinity of the reaction tube 16, they are configured to be capable of measuring a temperature (inner temperature) of the reaction tube 16.

The gas flow rate regulator 62 is configured to adjust a flow rate of the gas introduced into the reaction tube 16 through a gas introduction nozzle (not shown).

The flow rate sensor 64 is configured to measure the flow rate of the gas supplied into the reaction tube 16 through the gas introduction nozzle.

The pressure regulator 66 is configured to adjust a pressure (inner pressure) of the reaction tube 16.

The pressure sensor 68 is configured to measure the inner pressure of the reaction tube 16.

### <Controller>

The controller 60 includes a temperature controller (which is a temperature control apparatus) 74, a heater driver (which is a heater driving apparatus) 76 serving as an example of a power supply of the present disclosure, a flow rate controller (which is a flow rate control apparatus) 78 and a pressure controller (which is a pressure control apparatus) 80. By using components constituting the controller 60, the controller 60 is configured to control components constituting a semiconductor manufacturing apparatus serving as the substrate processing apparatus 10 based on values such as a set temperature value, a set pressure value and a set flow rate value (which are set by a control computer 82).

The temperature controller 74 is configured to control a power (that is, an electric power) supplied by heater drivers 76-1, 76-2, 76-3 and 76-4 (that is, the heater driver 76) to the temperature adjusting portions 72-1, 72-2, 72-3 and 72-4, respectively, such that the temperatures of the substrates 18 (which correspond to the temperature adjusting portions 72-1, 72-2, 72-3 and 72-4) measured by the first to fourth substrate temperature sensors 27-1, 27-2, 27-3 and 27-4, respectively, are adjusted (or set) to temperatures (which are set by the control computer 82) for the temperature adjusting portions 72-1, 72-2, 72-3 and 72-4, respectively. The heating structure may further include the heater driver 76 of the present embodiments. In addition, the heater driver 76 and the heater wire 30a may serve as an example of the heating structure according to the embodiments of the present disclosure.

The flow rate controller 78 is configured to control the flow rate of the gas introduced into the process chamber 24 of the reaction tube 16 by controlling the gas flow rate regulator 62 such that a gas flow rate value (which is measured by the flow rate sensor 64) is set to be equal to the set flow rate value (which is set by the control computer 82).

The pressure controller 80 is configured to control the inner pressure of the process chamber 24 of the reaction tube 16 by controlling the pressure regulator 66 such that the inner pressure of the reaction tube 16 (which is measured by the pressure sensor 68) is set to be equal to the set pressure value (which is set by the control computer 82).

### <Hardware Configuration>

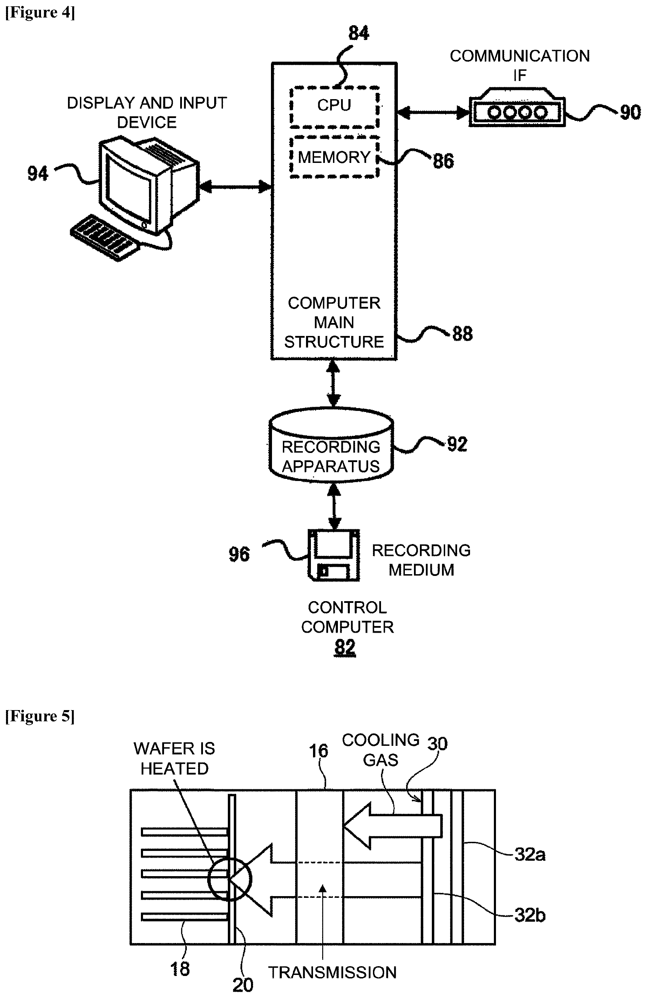

FIG. 4 is a diagram schematically illustrating a configuration of the control computer 82. For example, the control computer 82 includes: a computer main structure 88 including components such as a CPU 84 and a memory 86; a communication IF (Interface) 90; a recording apparatus 92, and a display and input device 94. In other words, the control computer 82 includes components of a general-purpose computer.

The CPU (Central Processing Unit) constitutes a backbone of a manipulator. The CPU is configured to execute a control program stored in the recording apparatus 92 and a recipe (for example, a process recipe) stored in the recording apparatus 92, in accordance with an instruction from the display and input device 94.

In addition, as a recording medium 96 for storing data such as an operation program of the CPU, a component such as a ROM (Read Only Memory), an EEPROM (Electrically Erasable Programmable Read Only Memory), a flash memory and a hard disk may be used. In the present embodiments, a RAM (Random Access Memory) functions as a component such as a work area of the CPU.

While the present embodiments will be described by way of an example in which the control computer 82 is used. However, the present embodiments are not limited thereto. For example, the present embodiments may also be applied when a general computer system is used. For example, by installing in the general-purpose computer a program for executing a processing (steps) described later from the recording medium 96 (such as a flexible disk, a CD-ROM and a USB) in which the program is stored, it is possible to perform the processing described above.

For example, the program may be provided through the communication IF 90 such as a communication line, a communication network and a communication system. In such a case, for example, the program may be posted on a bulletin board on the communication network, and may be provided by being superimposed on a carrier wave via the communication network. In addition, the program provided as described above may be executed to perform the processing described above under a control of an OS (operating system) just like any other application programs.

For example, the control program stored in the recording apparatus 92 is a program executed by the substrate processing apparatus 10 provided with the control computer 82 serving as a control structure. For example, the control computer 82 is configured to be capable of, by performing the program, setting the temperature of the substrate 18 in the reaction tube 16 to be equal to a process temperature by controlling a heating operation of heating the reaction tube 16 by the heating structure 30 in the reaction tube 16 and a cooling operation of cooling the reaction tube 16 by the cooling structure such as the exhaust fan 54 through which the cooling gas for cooling the reaction tube 16 is supplied. For example, the program mentioned above causes the control computer 82 to perform: (a) increasing a temperature of the heater wire 30a included in the heating structure 30 to be higher than the process temperature by supplying a constant power (that is, a constant amount of the power) to the heating structure 30; and (b) supplying the cooling gas toward the reaction tube 16 by using the cooling structure such as the exhaust fan 54.

Thereby, a predetermined power (a predetermined amount of the power) is applied to the heater wire 30a. As a result, it is possible to increase the temperature of the heater wire 30a higher than the process temperature of the substrate 18, and it is also possible to increase a proportion of a short wavelength components among various wavelength components of radiation (i.e., electromagnetic radiation) emitted from the heater wire 30a. In addition, since the cooling gas is supplied from the cooling structure toward the reaction tube 16, it is possible to cool the reaction tube 16 while applying the power to the heater wire 30a.

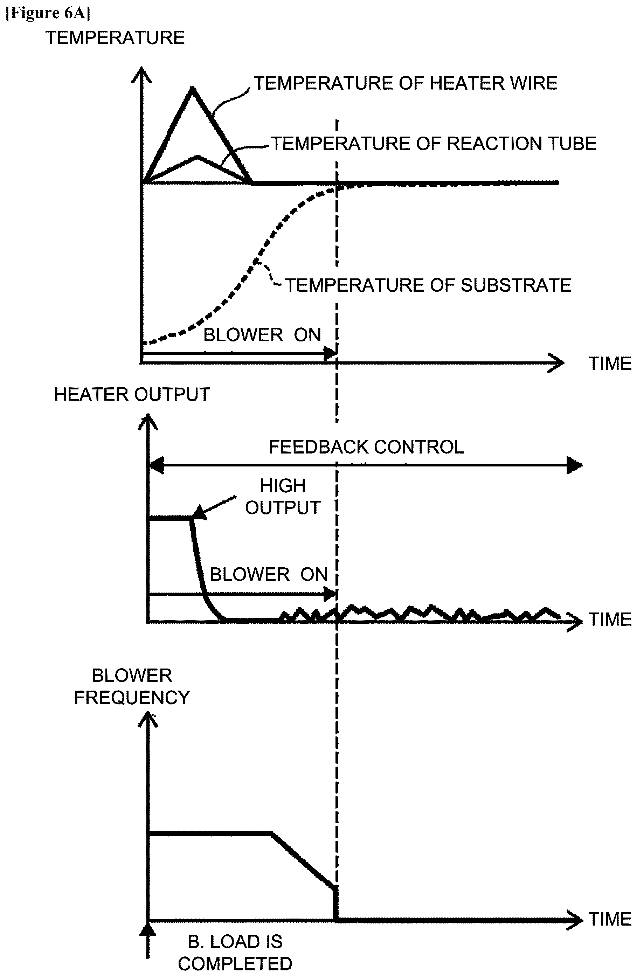

Subsequently, an example of a temperature control performed during a substrate processing being performed by the substrate processing apparatus 10 will be described with reference to FIG. 6A. Shown in FIG. 6A are a graph schematically illustrating a temperature change of each component (for example, the heater wire 30a, the reaction tube 16, the substrate 18 and the boat 20), a graph schematically illustrating a change in a heater output (that is, an output power of the heater wire 30a), and a graph schematically illustrating a blower frequency (a frequency of a blower) (for example, a motor rotation speed of the exhaust fan 54).

According to the temperature control of the present embodiments, for example, as shown in FIG. 6A, after the substrates 18 accommodated in the boat 20 are arranged in (or placed in) the furnace (that is, when a boat loading is completed), a feedback control is performed to efficiently heat an inside (inner portion) of the reaction tube 16 and to improve a temperature increase rate (in other words, a temperature increase speed) of the substrates 18 in the reaction tube 16. First, an overview of the temperature control in FIG. 6A will be described.

### Step (1) (Temperature Increasing Step)

First, when the temperature of the substrate 18 is increased from a temperature at a completion of the boat unloading to a stable target temperature (process temperature), the heater wire 30a is adjusted to a high output, such as a full power (a maximum output of the heating structure 30), in order to quickly increase the temperature of the heater wire 30a, and the high output (or an output higher than the high output) is maintained for a predetermined time. For example, the heater wire 30a is set to a constant output of the full power. A high output power is not limited to the maximum output of the heating structure 30. For example, the high output power is a power greater than a power sufficient to maintain the process temperature for processing the substrate 18 with a gas such as a process gas, and a value of the high output power is set in advance in the apparatus such as the substrate processing apparatus 10. In the present specification, the term "process temperature" refers to the temperature of the substrate 18. However, the term "process temperature" may refer to a temperature (inner temperature) of the process chamber 24 provided within the reaction tube 16.

In the present embodiments, when the heating structure 30 is maintained at the high output (or the output higher than the high output) for the predetermined time, the temperature of the heater wire 30a is configured to increase to a preset temperature (first set temperature). The preset temperature is determined to be at least a temperature at which the temperature of the substrate 18 does not exceed the process temperature (that is, at which no overshoot occurs). The preset temperature will be described in detail later.

Whereas it is possible to easily and quickly control the temperature of the heater wire 30a by the power supplied to the heater wire 30a, it is difficult to quickly change the inner temperature of the reaction tube 16 by performing a temperature control therefor similar to that for the heater wire 30a. In other words, it is difficult to control a secondary radiation from the reaction tube 16 (which is mostly an infrared radiation with a relatively long wavelength).

Therefore, in order to minimize an increase in the inner temperature of the reaction tube 16, at least in the step (1), the cooling gas is supplied to cool the reaction tube 16 while heating the substrate 18. In other words, according to the present embodiments, the heater wire 30a is adjusted to the high output, and a primary radiation (mostly with a relatively short wavelength) from the heater wire 30a, which is easy to control, is applied to the substrate 18. In addition, in order to suppress the secondary radiation from the reaction tube 16, the reaction tube 16 is cooled while the heater wire 30a is heating the substrate 18. As described above, it is possible to efficiently cool the reaction tube 16 by operating the exhaust fan 54 and blowing (or ejecting) the cooling gas through the blowout holes 35 toward the reaction tube 16.

In a manner described above, by applying the predetermined power to the heater wire 30a and increasing the temperature of the heater wire 30a to become higher than the process temperature of the substrate 18, it is possible to increase the proportion of the short wavelength components (whose wavelength is, for example, shorter than 4 µm) among the various wavelength components of the radiation emitted from the heater wire 30a. In addition, by supplying the cooling gas toward the reaction tube 16 (that is, by performing a cooling gas supply step), it is possible to cool the reaction tube 16 so as to suppress the secondary radiation with a long wavelength from the reaction tube 16 while applying the power to the heater wire 30a. Therefore, it is possible to suppress the secondary radiation with the long wavelength from the reaction tube 16 and it is also possible to increase an amount of the short wavelength radiation transmitted through the reaction tube 16. As a result, it is possible to efficiently heat the inside of the reaction tube 16, and it is also possible to improve the temperature increase rate (in other words, the temperature increase speed) of the substrate 18 in the reaction tube 16.

### Step (2) (Adjusting Step)

After the step (1), the step (2) of adjusting the temperature of the substrate 18 to reach the stable target temperature (process temperature) is performed. Specifically, a supply of the power to the heater wire 30a is adjusted. For example, an amount of the power supplied to the heater wire 30a may be set to zero. In addition, the blower frequency is adjusted. When the temperature of the substrate 18 approaches the process temperature, the blower frequency is suppressed and the supply of the cooling gas is adjusted. By feedback controlling both of the heater wire 30a and the blower frequency in a manner described above, it is possible to control the temperature of the substrate 18 to converge to the process temperature without overshooting.

### Step (3) (Stabilizing Step)

When the temperature of the substrate 18 reaches the process temperature after the step (2), in the feedback control, the temperature control is performed to stabilize the temperature of the substrate 18 at the target temperature. The temperature control is performed by measuring the temperature of the substrate 18 and controlling the output of the heater wire 30a. In the step (3), the temperature control may also be performed while continuously supplying the cooling gas whose temperature is low to cool the reaction tube 16. In other words, the blower may be turned on to supply the cooling gas.

In addition, when performing the feedback control while increasing the temperature of the substrate 18 in the steps (1) and (2) mentioned above, it may be affected by surrounding environments by following fluctuations in the environments. By, for example, designating the set temperature value such that the output of the heater wire 30a is at the high output as in the step (1), the time of maintaining the heater wire 30a at the high output can be adjusted by using the feedback control even when the fluctuations affect the temperature of the substrate 18. In step (2), by feedback controlling with designating the stable target temperature of the substrate 18 as the set temperature value, it is possible to adjust a standby time (waiting time) taken for the temperature of the substrate 18 to reach the stable target temperature.

For example, the heater wire 30a configured to heat the substrate 18 may be divided into a plurality of zones (a plurality of heat generating regions) such that each zone is controlled individually. When performing the temperature control in such a case, the temperature of the substrates 18 placed on the boat 20 can be adjusted to be uniform therebetween by performing the temperature control in the steps (1), (2) and (3) independently for each zone.

### <Supplement on Temperature Control>

In the adjusting step of adjusting the temperature of the substrate 18, a supply amount of the cooling gas and the power supplied to the heater wire 30a are adjusted such that the temperature of the substrate 18 reaches the process temperature. Thereby, it is possible to improve the temperature increase rate of the substrate 18 accommodated in the reaction tube 16, and it is also possible to shorten a time taken for the inner temperature of the reaction tube 16 to be stabilized at the process temperature from a start of the temperature increasing step. As a result, for example, it is possible to stabilize the temperature of the substrate at the process temperature in a short time.

As shown in FIG. 6A, by simultaneously starting the heating by the heater wire 30a (that is, the temperature increasing step) and the cooling gas supply step for cooling the reaction tube 16, as compared with a case where the cooling gas supply step is started later than the temperature increasing step, it is possible to improve the temperature increase rate of the substrate 18, and it is also possible to stabilize the temperature of the substrate 18 at the process temperature in a short time.

In addition, by supplying the predetermined power to the heater wire 30a in the temperature increasing step at the full power, as compared with a case where the full power is not supplied, it is possible to heat the substrate 18 more quickly by the short wavelength radiation.

By continuously supplying the predetermined power to the heater wire 30a in the temperature increasing step until the temperature of the heater wire 30a reaches the preset temperature higher than the process temperature, it is possible to efficiently heat the inside of the reaction tube 16, and for example, it is possible to improve the temperature increase rate of the substrate 18 in the reaction tube 16.

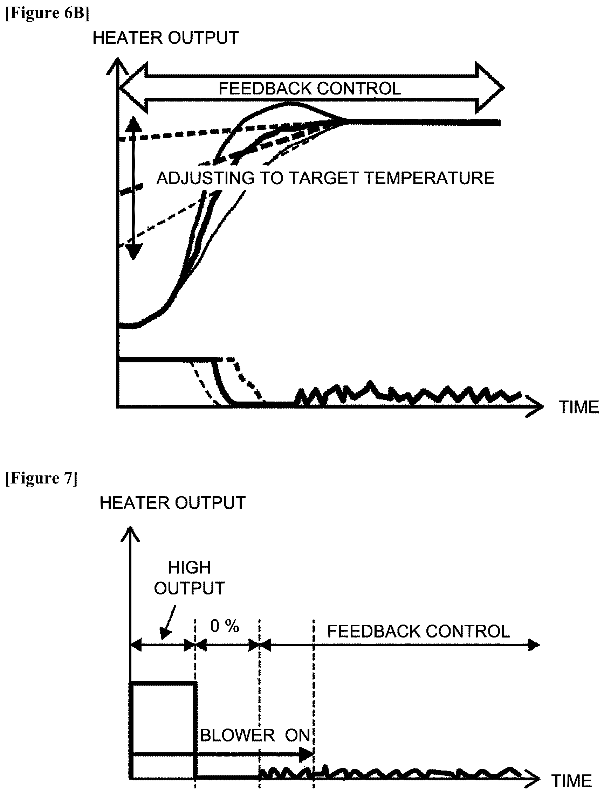

As shown in FIG. 6A, by reducing (decreasing) the power from the constant power after the temperature of the heater wire 30a in the temperature increasing step reaches the preset temperature higher than the process temperature, it is possible to return the temperature of the heater wire 30a from the temperature higher than the process temperature to an original temperature (that is, it is possible to reduce the temperature of the heater wire 30a), before the inner temperature of the reaction tube 16 reaches the process temperature. As a result, as shown in FIG. 6B, it is possible to suppress the overshoot (shown by an upper line in the graph) in which the temperature of the substrate 18 becomes excessively high, and it is also possible to stabilize the process temperature.

When the temperature of the heater wire 30a in the temperature increasing step reaches the preset temperature higher than the process temperature, the supply of the power to the heater wire 30a is stopped. Thereby, the temperature of the heater wire 30a returns to the original temperature from the temperature higher than the process temperature, before the inner temperature of the reaction tube 16 reaches the process temperature. That is, the temperature of the heater wire 30a is reduced. As a result, it is possible to suppress the overshoot in which the temperature of the substrate 18 becomes excessively high, and it is also possible to stabilize the process temperature.

The supply of the predetermined power to the heater wire 30a in the temperature increasing step is continuously performed until the temperature of the heater wire 30a reaches the preset temperature higher than the process temperature. However, it is preferable to set the preset temperature such that the short wavelength radiation can be obtained from radiant waves of the heater wire 30a. That is, it is preferable to set the temperature of the heater wire 30a to be higher than the process temperature of the substrate 18. As a result, it is possible to efficiently heat the inside of the reaction tube 16 (in particular, the substrate 18) by the short wavelength radiation, thereby improving the temperature increase rate of the substrate 18 in the reaction tube 16.

It is preferable that the preset temperature of the heater wire 30a is set to be 450 °C or higher (but the preset temperature of the heater wire 30a may set to be lower than 450 °C). When the temperature of the heater wire 30a is set to be lower than 450°C, it may not be possible to sufficiently obtain the short wavelength radiation (for example, whose wavelength is shorter than 4 µm) among the various wavelength radiations from the heater wire 30a. In such a case, the infrared radiation with the long wavelength emitted from the heater wire 30a may be absorbed by the reaction tube 16 to heat the reaction tube 16, and the substrate 18 arranged in the reaction tube 16 may not be sufficiently heated. In contrast, when the temperature of the heater wire 30a is set to be 450 °C or higher, it is possible to increase the proportion of the short wavelength components among the various wavelength components of the radiations emitted from the heater wire 30a. Such a short wavelength radiation penetrates the reaction tube 16 and is absorbed by the substrate 18 arranged in the reaction tube 16. Thereby, it is possible to contribute to improving a temperature increase efficiency. In addition, for example, when the temperature of the heater wire 30a reaches 800 °C or higher, most of the radiations emitted from the heater wire 30a become the short wavelength radiation. In a manner described above, the temperature of the heater wire 30a can be increased. Thereby, more infrared radiation with a short wavelength can be emitted so that the infrared radiation with the short wavelength penetrates the reaction tube 16 and is absorbed by the substrate 18 arranged in the reaction tube 16. As a result, it is possible to improve the temperature increase efficiency.

A supply time for which the constant power is supplied to the heater wire 30a can be determined in accordance with the process temperature. When the inner temperature of the reaction tube 16 is increased while the temperature of the heater wire 30a is set to be higher than the process temperature, it is possible to, for example, increase a proportion of the infrared radiation with the short wavelength among various infrared radiations emitted from the heater wire 30a. Then, the infrared radiation with the short wavelength penetrates the reaction tube 16 and is absorbed by the substrate 18 arranged in the reaction tube 16. As a result, it is possible to improve the temperature increase efficiency. In addition, it is possible to reduce the temperature of the heater wire 30a from the preset temperature higher than the process temperature to the original temperature (for example, the process temperature). By determining the supply time for which the constant power is supplied to the heater wire 30a in accordance with the process temperature, it is possible to achieve both of the temperature increase efficiency and the temperature stabilization.

The supply amount of the cooling gas supplied in the cooling gas supply step may be controlled until the temperature of the heater wire 30a reaches the preset temperature. As a result, the reaction tube 16 is cooled until the temperature of the heater wire 30a reaches the preset temperature, and the infrared radiation with the long wavelength from the reaction tube 16 is suppressed until the temperature of the heater wire 30a reaches the preset temperature.

The supply amount of the cooling gas supplied in the cooling gas supply step may be controlled until the temperature of the heater wire 30a reaches the process temperature from the temperature at the completion of the boat unloading. As a result, it is possible to cool the reaction tube 16 from a time before the temperature of the heater wire 30a reaches the preset temperature, and it is also possible to suppress the infrared radiation with the long wavelength from the reaction tube 16 even when the temperature of the heater wire 30a reaches the preset temperature higher than the process temperature.

The supply amount of the cooling gas supplied in the cooling gas supply step may be reduced after the inner temperature of the reaction tube 16 reaches the process temperature. As a result, it is possible to suppress the overshoot in which the temperature of the substrate 18 becomes excessively high, and it is also possible to stabilize the process temperature.

By setting the temperature of the heater wire 30a and the process temperature to be equal to each other when the inner temperature of the reaction tube 16 starts to increase and when the inner temperature of the reaction tube 16 reaches the process temperature, it is possible to suppress the secondary radiation with the long wavelength from the reaction tube 16. As a result, it is possible to increase the amount of the short wavelength radiation transmitted through the reaction tube 16, and it is also possible to efficiently heat the inside of the reaction tube 16.

The process temperature may be set to be lower than a standby temperature of the heater wire 30a which is a temperature maintained while no substrate 18 is arranged in the reaction tube 16 (for example, in a standby state before the substrate 18 accommodated in the boat 20 is inserted into the furnace). Thereby, by the temperature control for a process performed within a low temperature range lower than the standby temperature of the heater wire 30a (which is the temperature maintained while no substrate 18 is arranged in the reaction tube 16), it is possible to adjust the temperature of the heater wire 30a, thereby increasing the proportion of the short wavelength components (whose wavelength is, for example, shorter than 4 µm) among the various wavelength components emitted from the heater wire 30a. As a result, for example, infrared rays with a high proportion of the short wavelength components are emitted from the heater wire 30a to penetrate the reaction tube 16. Thereby, it is possible to improve the temperature increase rate of the substrate 18 in the reaction tube 16.

FIG. 7 is diagram schematically illustrating an example in which the output of the heater wire 30a is set to the high output for a predetermined time without performing the feedback control, then the output of the heater wire 30a is set to zero and maintained for a predetermined time, and then the feedback control is performed. In addition, when the temperature of the substrate 18 exceeds the stable target temperature (beyond an allowable range), the time (predetermined time) for which the output of the heating structure 30 is maintained at the high output is shortened, and when the temperature of the substrate 18 falls below the stable target temperature, the time (predetermined time) for which the output of the heating structure 30 is maintained at the high output is lengthened, and an optimal predetermined time is determined. In addition, a blower output (an output of the blower) is set to be constant.

FIG. 6A also shows an example in which the step (I) is performed with a constant high output, and the step (II) is performed with a constant low output (zero power in FIG. 7). According to the example shown in FIG. 6A, merely by setting the times for the step (I) and the step (II), an operator (operating personnel) with a certain level of knowledge and skill can easily derive the optimal predetermined time. In addition, the feedback control is performed from a start of the step (III). However, according to the present embodiments, the feedback control of the heating structure 30 (or the heating structure 30 and the blower) may also be performed from a middle of the step (II).

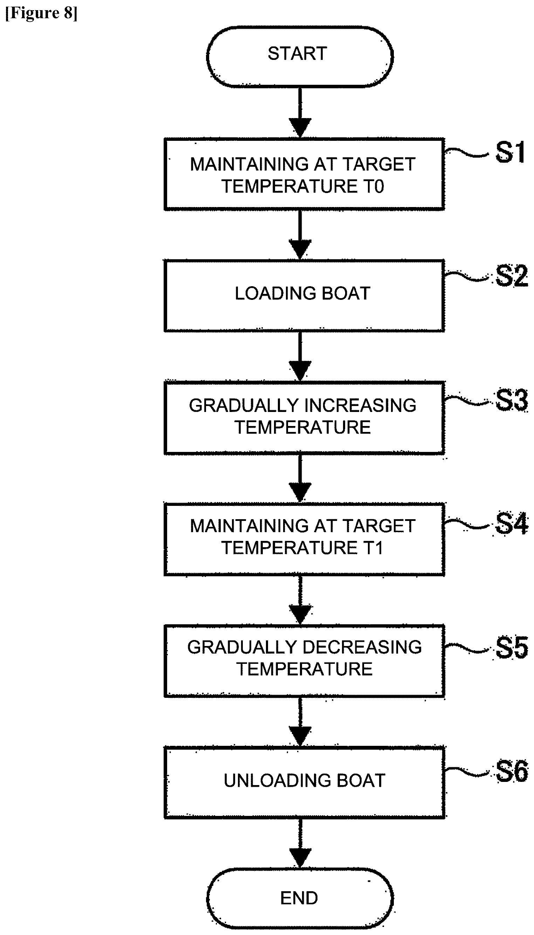

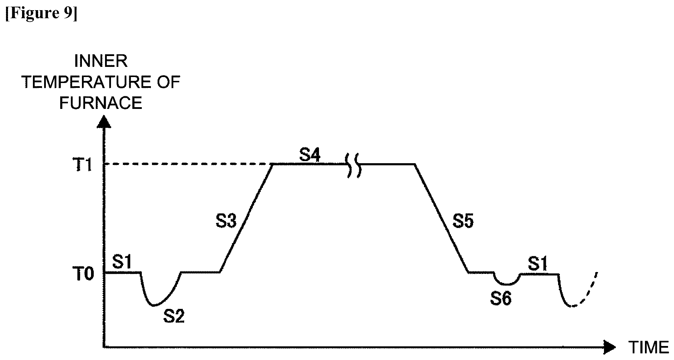

Hereinafter, an example of a film forming process performed by the substrate processing apparatus 10 will be described with reference to FIGS. 8 and 9. In the example shown in FIGS. 8 and 9, a standby temperature T0 is set to be lower than a target temperature T1.

A step S1 is a process of stabilizing a temperature (inner temperature) of the furnace at a relatively low temperature T0. In the step S1, the substrate 18 has not yet been inserted into the furnace.

A step S2 is a process of inserting (loading) the substrate 18 accommodated in the boat 20 into the furnace. The temperature of the substrate 18 is lower than the inner temperature T0 of the furnace when the substrate 18 is inserted into the furnace. Thereby, the inner temperature of the furnace temporarily falls below the temperature T0. However, the inner temperature of the furnace is stabilized again at the temperature T0 after some time by using components such as the temperature controller 74.

A step S3 is a process of gradually increasing the inner temperature of the furnace from the temperature TO to the target temperature T1 for performing the film forming process on the substrate 18.

A step S4 is a process of maintaining and stabilizing the inner temperature of the furnace at the target temperature T1 in order to perform the film forming process on the substrate 18.

A step S5 is a process of gradually decreasing the inner temperature of the furnace from the target temperature T1 to the relatively low temperature TO again after the film forming process is completed.

A step is a process of transferring (unloading) the substrate 18 (which is processed by the film forming process) out of the furnace together with the boat 20.

For example, when there is an unprocessed substrate 18 remaining on which the film forming process is to be performed, the substrate 18 (which is processed) on the boat 20 is replaced with the unprocessed substrate 18, and a series of processes of the steps S1 through S6 are performed (repeatedly performed).

In each of the steps S1 to S6, its subsequent step is performed after a stable state is reached (that is, the inner temperature of the furnace is within a predetermined minute temperature range with respect to the target temperature and such a state continues for a predetermined time) . Alternatively, recently, in order to increase the number of the substrates 18 processed for a given time, the subsequent step may be performed even when the stable state is not yet reached in some steps such as the step S1, the step S2, the step S5 and the step S6.

In the present embodiments, the step S3 (temperature increasing step) and the step S5 (temperature decreasing step) is not indispensable. The reason why step S3 (temperature increasing step) and the step S5 (temperature decreasing step) are performed is because the standby temperature T0 and the target temperature T1 (process temperature) are different from each other. Therefore, when the standby temperature T0 is equal to the target temperature T1 (process temperature), the step S3 (temperature increasing step) and the step S5 (temperature decreasing step) are omitted. In addition, the step S3 (temperature increasing step) may be omitted also when the target temperature T1 is lower than the standby temperature T0.

### <Other Embodiments of Present Disclosure>

The technique of the present disclosure may also be applied not only to the semiconductor manufacturing apparatus but also to an apparatus capable of processing a glass substrate such as an LCD (Liquid Crystal Display) device. For example, even when an apparatus capable of heating and processing the glass substrate with a heater wire is used, it is possible to obtain substantially the same effects as those of the embodiments described above.

In addition, the technique of the present disclosure may be applied to a semiconductor manufacturing technique, in particular, a heat treatment technique capable of performing a processing while a substrate to be processed is accommodated in a process chamber and heated by a heater. For example, the technique of the present disclosure may be effectively applied to a substrate processing apparatus configured to perform, on a semiconductor substrate on which a semiconductor integrated circuit (semiconductor device) is manufactured, the processing such as an oxidation process, a diffusion process, an annealing process or a reflow process for a carrier activation or a planarization after an ion implantation, and a film-forming process by using a thermal CVD (Chemical Vapor Deposition) reaction.

In the present specification, the term "substrate" may refer to "a substrate itself", or may refer to "a substrate and a stacked structure (aggregated structure) of a predetermined layer (or layers) or a film (or films) formed on a surface of the substrate".

The entire contents of Japanese Patent Application No. 2022-209067, filed on December 26, 2022, are hereby incorporated in the present specification by reference. All documents, patent applications, and technical standards described in the present specification are hereby incorporated in the present specification by reference to the same extent that the contents of each of the documents, the patent applications and the technical standards are specifically described.

### [Industrial Applicability]

The technique of the present disclosure can also be applied to a substrate processing apparatuses provided with a plurality of substrate retainers and configured to process a plurality of substrates accommodated in each of the substrate retainers. In particular, the technique of the present disclosure can be applied to a substrate processing apparatus configured to process a plurality of substrates at a low temperature.

### [Description of Reference Numerals]

| | | | |
|---|---|---|---|
| 16 | reaction tube | 18 | substrate |

## Claims

1. A temperature control method comprising:
a process temperature setting step of adjusting a temperature of a substrate arranged in a reaction tube to a predetermined process temperature by controlling a heating of an inside of the reaction tube and a cooling of the inside the reaction tube, wherein the process temperature setting step comprises:
a temperature increasing step of increasing a temperature of a heater wire provided outside the reaction tube to become higher than the process temperature by supplying a constant amount of an electric power to the heater wire; and
a cooling gas supply step of supplying a cooling gas toward the reaction tube.

2. The temperature control method of claim 1, further comprising
an adjusting step of adjusting the temperature of the substrate to the process temperature by adjusting a supply amount of the cooling gas and the electric power.

3. The temperature control method of claim 1, wherein the temperature increasing step and the cooling gas supply step are started simultaneously.

4. The temperature control method of claim 2, wherein the adjusting step and the cooling gas supply step are performed simultaneously.

5. The temperature control method of claim 1, wherein the constant amount of the electric power is continuously supplied in the temperature increasing step until the temperature of the heater wire reaches a preset temperature higher than the process temperature.

6. The temperature control method of claim 1, wherein an amount of the electric power supplied to the heater wire is controlled to be reduced from the constant amount of the electric power when the temperature of the heater wire in the temperature increasing step reaches a preset temperature higher than the process temperature.

7. The temperature control method of claim 6, wherein a supply of the electric power is stopped when the temperature of the heater wire in the temperature increasing step reaches the preset temperature higher than the process temperature.

8. The temperature control method of claim 5, wherein the preset temperature is set so as to obtain a short wavelength radiation from radiation waves of the heater wire.

9. The temperature control method of claim 2, wherein the temperature of the heater wire is controlled to be reduced to the process temperature before the adjusting step is completed.

10. The temperature control method of claim 5, wherein a supply time of the constant amount of the electric power is determined in accordance with the process temperature.

11. The temperature control method of claim 1, wherein a supply amount of the cooling gas in the cooling gas supply step is controlled until the temperature of the heater wire reaches a preset temperature higher than the process temperature.

12. The temperature control method of claim 1, wherein a supply amount of the cooling gas in the cooling gas supply step is controlled from a time before the temperature of the heater wire reaches a preset temperature higher than the process temperature and until the temperature of the heater wire reaches the process temperature.

13. The temperature control method of claim 1, wherein a supply amount of the cooling gas in the cooling gas supply step is reduced when an inner temperature of the reaction tube approaches the process temperature.

14. The temperature control method of claim 1, wherein the temperature of the heater wire and the process temperature are controlled such that the temperature of the heater wire is equal to the process temperature when an inner temperature of the reaction tube starts to be increased and when the inner temperature of the reaction tube reaches the process temperature.

15. The temperature control method of claim 14, wherein the process temperature is lower than a standby temperature of the heater wire maintained in a state where no substrate is arranged in the reaction tube.

16. A method of manufacturing a semiconductor device, comprising
adjusting a temperature of a substrate to a process temperature by using the temperature control method of claim 1,
wherein the substrate arranged in the reaction tube is processed while maintaining the process temperature.

17. A program related to a substrate processing apparatus comprising a controller configured to be capable of adjusting a temperature of a substrate in a reaction tube to a process temperature by controlling a heating of an inside of the reaction tube by a heating structure and a cooling of the inside the reaction tube by a cooling structure configured to supply a cooling gas to the reaction tube, wherein the program causes, by a computer, the substrate processing apparatus to perform:
a sequence of increasing a temperature of a heater wire contained in the heating structure to become higher than the process temperature by supplying the heating structure with a predetermined amount of an electric power by the power supply; and
a sequence of supplying the cooling gas toward the reaction tube by the cooling structure.

18. A substrate processing apparatus comprising:
a reaction tube in which a substrate is arranged;
a heater comprising a heating structure configured to heat the substrate in the reaction tube and a power supply configured to supply an electric power to the heating structure;
a cooling structure configured to supply a cooling gas to the reaction tube; and
a controller configured to be capable of adjusting a temperature of the substrate in the reaction tube to a process temperature by controlling a heating of an inside of the reaction tube and a cooling of the inside the reaction tube,
wherein the controller is further configured to be capable of at least performing:
a process of increasing a temperature of a heater wire contained in the heating structure to become higher than the process temperature by supplying a predetermined amount of the electric power by the power supply; and
a process of supplying the cooling gas toward the reaction tube by the cooling structure.
